# EUROPÄISCHE PATENTSCHRIFT

(11) **EP 0 625 285 B1**
(45) Veröffentlichungstag und Bekanntmachung des Hinweises auf die Patenterteilung: **22.03.2000**
(21) Anmeldenummer: 94900729.8
(22) Anmeldetag: 27.11.1993
(51) Int. Cl.: H01L 21/306, H01L 21/308

(54) **VERFAHREN ZUM ANISOTROPEN ÄTZEN VON SILICIUM**
METHOD FOR ANISOTROPICALLY ETCHING SILICON
PROCEDE D'ATTAQUE ANISOTROPE DU SILICIUM

(30) Priorität: 05.12.1992 DE 4241045
(43) Veröffentlichungstag der Anmeldung: 23.11.1994
(73) Patentinhaber: ROBERT BOSCH GMBH, 70442 Stuttgart (DE)
(72) Erfinder: LAERMER, Franz, D-70437 Stuttgart (DE); SCHILP, Andrea, D-73525 Schäbisch Gmünd (DE)
(86) Internationale Anmeldenummer: DE9301129
(87) Internationale Veröffentlichungsnummer: WO9414187

(56) Entgegenhaltungen:
- EP-A- 0 200 951
- EP-A- 0 298 204
- EP-A- 0 363 982
- EP-A- 0 383 570
- EP-A- 0 497 023
- WO-A-88/09830
- US-A- 4 579 623
- US-A- 4 795 529
- PATENT ABSTRACTS OF JAPAN vol. 15, no. 340 (E-1105)28. August 1991 & JP,A,03 129 820 (MASAHARU) 3. Juni 1991
- JOURNAL OF VACUUM SCIENCE AND TECHNOLOGY: PART B. Bd. 5, Nr. 3 , Juni 1987 , NEW YORK US Seiten 657 - 666 MAHI ET AL 'The etching of silicon in diluted SF6 plasmas : correlation between the flux of incident species and the etching kinetics'
- JOURNAL OF THE ELECTROCHEMICAL SOCIETY Bd. 138, Nr. 10 , Oktober 1991 , MANCHESTER, NEW HAMPSHIRE US Seiten 3094 - 3100 TIN ET AL 'Effects of RF bias on remote microwave plasma assisted etching of silicon in SF6'
- J. Vac. Sc. Technol., Bd. 9, Nr. 1, S. 1-7

## Beschreibung

Die Erfindung betrifft ein Verfahren zum anisotropen Plasmaätzen von mit einer Ätzmaske lateral exakt definierten Strukturen in einem Siliziumsubstrat nach dem Oberbegriff des Anspruchs 1.

Es ist bekannt, in Siliciumsubstrate, die vorzugsweise in der Halbleitertechnik angewendet werden, definierte Strukturen, beispielsweise Gräben, Kämme, Zungen, Biegebalken oder ähnliches mit geringer bis mittlerer Selektivität anisotrop einzuätzen.

Die einzelnen einzuätzenden Strukturen werden üblicherweise durch auf das Siliciumsubstrat aufgebrachte Ätzsmasken über sogenannte Maskierschichten, beispielsweise eine Photolackschicht, definiert.

Bei der anisotropen Ätztechnik ist es notwendig, zu einer lateral exakt definierten Ausnehmung im Silicium zu kommen. Diese in die Tiefe gehenden Ausnehmungen müssen möglichst genau senkrechte Seitenabschlüsse besitzen. Dabei dürfen die Ränder der Maskierschichten, die diejenigen Siliciumsubstratbereiche abdecken, die nicht geätzt werden sollen, nicht unterätzt werden, um die laterale Genauigkeit der Strukturübertragung von der Maske ins Silicium so hoch wie möglich zu halten. Daraus ergibt sich die Notwendigkeit, die Ätzung also nur auf dem Strukturgrund, nicht aber an den bereits erzeugten Seitenwänden der Strukturen fortschreiten zu lassen.

Hierzu ist bereits vorgeschlagen worden, das Ätzen von Profilen in Siliciumsubstraten mit einem Plasmaätzverfahren durchzuführen. Dazu werden in einem Reaktor mit Hilfe einer elektrischen Entladung in einem Reaktivgasgemisch chemisch reaktive Spezies und elektrisch geladene Teilchen (Ionen) erzeugt. Die so generierten, positiv geladenen Kationen werden durch eine elektrische Vorspannung, die am Siliciumsubstrat anliegt, zum Substrat hin beschleunigt und fallen annähernd senkrecht auf die Substratoberfläche und fördern auf dem Ätzgrund die chemische Umsetzung der reaktiven Plasmaspezies mit dem Silicium.

Durch den nahezu senkrechten Einfall der Kationen soll die Ätzung an den Seitenwänden der Strukturen entsprechend langsam - bzw. im Optimalfall überhaupt nicht - voranschreiten.

Es ist bekannt, für diese Plasmaätzverfahren ungefährliche und prozeßstabile Reaktivgase auf Fluorchemiebasis einzusetzen. Dabei ist jedoch sehr nachteilig, daß diese auf Fluorchemiebasis wirkenden Reaktivgase zwar eine sehr hohe Ätzrate und eine hohe Selektivität ermöglichen, aber ein ausgeprägtes isotropes Ätzverhalten zeigen.

Die im Plasma generierten Fluorradikale weisen dabei gegenüber dem Silicium eine so hohe spontane Reaktionsrate auf, daß auch die Strukturkanten (Seitenflächen) schnell angeätzt werden und es somit zu der unerwünschten Unterätzung der Maskenkanten kommt.

Weiterhin ist bereits vorgeschlagen worden, die Seitenwände während der Ätzung mit gleichzeitig im Plasma befindlichen Polymerbildnern zu bedecken und durch diesen Polymerfilm zu schützen. Da sich dieser Polymerfilm auch auf dem Ätzgrund bilden würde, soll ein beständiger Ioneneinfall diesen von Polymer freihalten und die Ätzung dort ermöglichen. Hierbei ist jedoch nachteilig, daß die dem Plasma zugesetzten Polymerbildner, die sich zum Teil aus dem Fluorträger selbst durch Abspaltung von Fluorradikalen bilden oder die aus bewußt zugesetzten ungesättigten Verbindungen entstehen oder aus erodiertem organischen Maskenmaterial (z.B. Photolack) stammen, gegenüber den Fluorradikalen als Rekombinationspartner auftreten. Durch diese, ein chemisches Gleichgewicht anstrebende Rückreaktion wird ein erheblicher Teil des für die Ätzung benötigten Fluors neutralisiert, während gleichzeitig auch ein entsprechender Anteil der für die Seitenwandpassivierung benötigten Polymerbildner verlorengeht. Hierdurch wird insgesamt die mit diesem Verfahren erzielbare Ätzrate merklich gesenkt.

Diese Abhängigkeit der ätzenden Fluorradikale zu den ungesättigten Polymerbildnern im Plasma läßt die Ätzraten und die Ätzprofile von der freien zu ätzenden Siliciumsubstratfläche abhängig werden. Weiterhin ist noch nachteilig, daß die im Plasma anwesenden, die Polymerbildner ergebenden, ungesättigten Spezies bevorzugt bestimmte Maskenmaterialien ätzen und so die Selektivität, also das Verhältnis von Siliciumätzrate zur Maskenätzrate, verschlechtern. Darüber hinaus erfolgt ein ungleichmäßiger Seitenwandschutz, so werden die Seitenwände unmittelbar am Maskenrand bevorzugt mit Polymer beschichtet und somit die Seitenwand in diesem Bereich besser geschützt als in fortschreitender Ätztiefe der Strukturen.

Damit nimmt in größeren Tiefen die Polymerbedeckung der Seitenwände rasch ab und es erfolgt dort eine Unterätzung mit der Folge, daß flaschenartige Ätzprofile entstehen.

Anstelle des Einsatzes von Reaktivgasen auf Fluorbasis ist bereits vorgeschlagen worden, Reaktivgase auf Basis weniger reaktionsfreudiger Halogene, insbesondere Chlor und Brom, bzw. Reaktivgase, die im Plasma Chlor bzw. Brom freisetzen, einzusetzen.

Diese Reaktivgase bieten zwar den Vorteil, da deren im Plasma gebildete Radikale eine wesentlich geringere spontane Umsetzung mit Silicium zeigen und erst mit gleichzeitiger Ionenunterstützung zu einer Ätzung führen, daß sie, da die Ionen nahezu senkrecht auf das Siliciumsubstrat auftreffen, im wesentlichen nur auf dem Strukturgrund und nicht an den Seitenwänden der Struktur ätzen. Es besteht jedoch der Nachteil, daß diese Reaktivgase außerordentlich empfindlich gegenüber Feuchtigkeit reagieren.

Damit sind nicht nur aufwendige Einschleusvorrichtungen für die Siliciumsubstrate in dem Raktor notwendig, sondern auch die Leckrate der gesamten Ätzanlage muß extrem niedrig gehalten werden. Schon das geringste Auftreten von Reaktorfeuchtigkeit führt zu einer Mikrorauhigkeit auf dem Siliciumätzgrund infolge lokaler Siliciumoxydation und damit zum völligen Erliegen der Ätzung.

Aus der US-A-4,795,529 ist ein anistroper Plasmaätzprozeß mit einem stationären Gasgemisch von SF₆ als Ätzgas und C₂CL₃F₃ als Passiviergas bekannt. Während hierbei die aus SF₆ im Plasma freigesetzten Fluorradikale eine Siliciumätzung bewirken, bewirken die aus dem Trichlortrifluorethan gleichzeitig im Plasma erzeugten Chlorradikale und Fluorchlorpolymere eine Seitenwandpassivierung. Um die Anisotropie des Prozesses zu verbessern wird abwechselnd mit und ohne Ionenbeschleunigungsspannung an der Substratelektrode gearbeitet. In den Ätzschritten wird dabei eine starke Ionenbeschleunigung zum Siliciumwafer erreicht mit dem entsprechenden Ätzfortschritt, in den Depositionschritten, in denen die Ionenbeschleunigung abgeschaltet ist, wird dagegen eine Passivierungsschicht abgeschieden. Die Zusammensetzung des Plasmagasgemisches wird bei diesem Prozeß so gewählt, daß durch die Anlegung der Ionenbeschleunigungsspannung zwischen Deponieren und Ätzen umgeschaltet werden kann. Dennoch bildet sich während der Depositionsschritte auch am Ätzgrund eine Passivierungsschicht, die nachfolgend im nächsten Ätzschritt, d. h. bei Anlegen einer hohen Ionenbeschleunigungsspannung an die den Wafer tragende Substratelektrode, durchbrochen werden muß.

Aus der EP-A-0 363 982 ist ein Trockenätzverfahren von Gegenständen bekannt, das aus zwei alternierend durchgeführten Schritten besteht. In einem Schritt wird ein Ätzgas, in dem anderen Schritt ein Gas, welches unter Plasmaeinwirkung eine Polymerschicht auf dem Gegenstand bildet, in eine Reaktionskammer geführt. Beide Gase werden durch Mikrowellenanregung in den Plasmazustand überführt. Wesentlich an diesem bekannten Verfahren ist die Tatsache, daß eine Hochfrequenzanregung des Substrates, d. h. ein Ionenbombardement desselben, zu Beginn des Ätzschrittes durch eine Energiequelle mit hoher Leistung erfolgt, und daß diese Anregung nur kurze Zeit dauert. Der eigentliche Ätzprozeß verläuft dabei ohne Hochfrequenzanregung und damit ohne Ionenunterstützung. Es handelt sich also hierbei um eine sehr spezielle Art der Verfahrenssteuerung und außerdem basiert der Polymerisationsschritt auf einem chlorhaltigen und nicht auf einem fluorhaltigen Polymer.

Aus der EP-A-0 200 951 ist ein Verfahren zum anisotropen Ätzen von Silicium in einem fluorhaltigen Plasma bekannt. Hierbei handelt es sich um einen EIN-SCHRITT-Plasmaätzprozeß, bei dem zwar der Einsatz fluorhaltiger Prozeßgase beschrieben ist, dies jedoch bei einem Verfahren, bei dem keine alternierenden Polymerisations- und Ätzschritte durchgeführt werden. Ein anisotroper Ätzprozeß mit gutem Ergebnis, d. h. geringer Hinterätzung der Maske, kommt hierbei nicht zustande.

Der Erfindung liegt die Aufgabe zugrunde, ein Verfahren der gattungsgemäßen Art zu schaffen, mit dem auf Fluorchemiebasis eine hohe anisotropische Ätzung von Siliciumsubstraten bei gleichzeitig hoher Selektivität erreicht werden kann.

Erfindungsgemäß wird die Aufgabe durch die kennzeichnenden Merkmale des Anspruchs 1 gelöst.

Infolge der Durchführung der anisotropen Ätzung in separaten, jeweils alternierend aufeinanderfolgenden Ätz- und Polymerisationsschritten werden die gleichzeitige Anwesenheit von Ätzspezies und Polymerbildern im Plasma vermieden. So können mit sehr hohen Ätzraten tiefe Strukturen mit senkrechten Kanten in Siliciumsubstraten realisiert werden.

Weitere vorteilhafte Ausgestaltungen der Erfindung ergeben sich aus den in den Unteransprüchen aufgeführten Merkmalen.

Durch das erfindungsgemäße Verfahren muß beim Ätzschritt keinerlei Rücksicht auf ein bestimmtes Verhältnis von gesättigten zu ungesättigten Spezies, also von Flourradikalen zu Polymerbildnern, genommen werden, so daß der eigentliche Ätzschritt an sich hinsichtlich Ätzrate und Selektivität optimiert werden kann, ohne daß die Anisotropie des Gesamtprozesses darunter leidet.

Gemäß der Erfindung werden die Siliciumsubstrate während der Ätzschritte und wahlweise auch während der Polymerisationsschritte mit Ionenenergie bombardiert. Durch diese gleichzeitige Bombardierung mit Ionenenergie wird vorteilhaft erreicht, daß auf dem Ätzgrund sich kein Polymer bilden kann, so daß während des Ätzschrittes eine höhere Ätzrate erreicht werden kann, da eine vorhergehende notwendige Zersetzung der Polymerschicht auf dem Ätzgrund nicht mehr notwendig ist.

Es hat sich gezeigt, daß ein sehr gutes anisotropes Ergebnis mit außerordentlich niedriger Ionenenergie erreicht werden kann. Infolge der nur geringen benötigten Ionenenergie ist eine ausgezeichnete Maskenselektivität erreichbar.

Da die durch das erfindungsgemäße Verfahren möglichen hohen Ätzraten zu einer stark exothermen chemischen Umsetzung von Fluorradikalen mit Silicium führen, kann es zu einer beträchtlichen Erwärmung des Siliciumsubstrates kommen.

Vorteilhafterweise wird das Siliciumsubstrat während des Ätzvorgangs, vorzugsweise durch einen Heliumgasstrom, gekühlt. Durch die gleichzeitige Kühlung des Siliciumsubstrats während des Ätzvorgangs können die Vorteile des erfindungsgemäßen Verfahrens, nämlich eine sehr hohe Ätzrate bei gleichzeitig hoher Selektivität, voll ausgenutzt werden.

Die Erfindung wird nachfolgend anhand einer Zeichnung, die schematisch den Aufbau einer für das Verfahren einsetzbaren Ätzvorrichtung zeigt, näher erläutert.

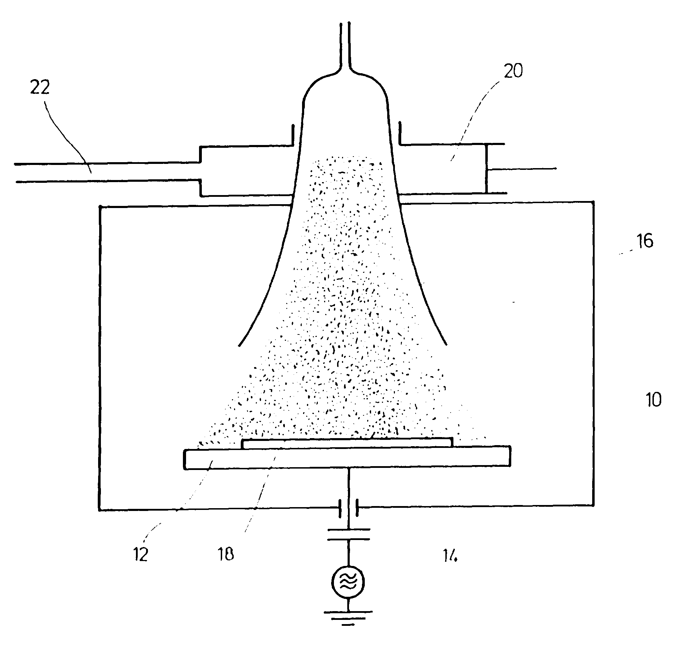

Die Figur zeigt eine Ätzkammer 10, in der eine Substratelektrode 12 angeordnet ist, die mit einer Hochfrequenzspeisung 14 verbunden ist.

In die Ätzkammer 10 ragt weiterhin ein Surfatron 16 hinein. Im Wirkbereich des Surfatrons 16 ist auf der Substratelektrode 12 ein Siliciumsubstrat 18 angeordnet. Das Surfatron 16 ist mit einem Resonator 20 zur Mikrowellenplasmaanregung gekoppelt. Die Anlage weist weiterhin einen Hohlleiter 22 zum Heranführen eines Reaktivgases auf.

Das erfindungsgemäße Verfahren zum anisotropen Ätzen von Siliciumsubstrat läuft nunmehr auf folgende Weise ab.

Der Übersichtlichkeit halber wird bei der nun folgenden Verfahrensbeschreibung auf einzelne Bezugnahmen zu der Ätzkammer 10, in der die Verfahrensschritte ablaufen, verzichtet.

Die Ätzkammer 10 ist auch nur beispielhaft ausgewählt worden, und die Erfindung bezieht sich im einzelnen nicht auf den konkreten Aufbau der Ätzkammer 10. Das erfindungsgemäße Verfahren kann selbstverständlich auch mit einer analogen, die einzelnen Verfahrensschritte vollziehenden Vorrichtung durchgeführt werden.

Ein entsprechend vorbereitetes Siliciumsubstrat, das heißt ein mit einer Ätzmaske, beispielsweise aus Photolack, beschichtetes Siliciumsubstrat, wobei die Ätzmaske die Bereiche des Siliciumsubstrats freiläßt, die anisotrop eingeätzt werden sollen, wird einem ersten Ätzschritt ausgesetzt.

Dazu wird ein Gemisch von beispielsweise Schwefelhexafluorid SF₆ und Argon Ar eingesetzt, das einen Gasfluß zwischen 0 und 100 sccm und einen Prozeßdruck zwischen 10 und 100 µbar aufweist. Die Plasmaerzeugung erfolgt hierbei vorzugsweise mit einer Mikrowelleneinstrahlung bei Leistungen zwischen 300 und 1200 W (2,45 GHz).

Gleichzeitig wird an die Substratelektrode eine Substratvorspannung zur Ionenbeschleunigung angelegt. Die Substratvorspannung liegt vorzugsweise zwischen 5 und 30 V und kann mit einer Hochfrequenzeinspeisung (13,56 MHz) bei Leistungen zwischen 2 und 10 W erreicht werden.

Während des Ätzschrittes werden in dem Reaktor - hier Surfatron - mit Hilfe einer elektrischen Entladung in dem Gemisch aus Schwefelhexafluorid und Argon chemisch reaktive Spezies und elektrisch geladene Teilchen (Ionen) erzeugt.

Die so generierten, positiv geladenen Kationen werden durch die an der Substratelektrode angelegte elektrische Vorspannung zum Siliciumsubstrat hin beschleunigt und fallen annähernd senkrecht auf die durch die Ätzmaske freigelassene Substratoberfläche ein und fördern die chemische Umsetzung der reaktiven Plasmaspezies mit dem Silicium.

Der Ätzschritt kann z.B. so lange durchgeführt werden, bis eine Ätztiefe von ca. 2 - 3 µm Tiefe erreicht ist.

Im Anschluß wird ein erster Polymerisationsschritt mit einem Gemisch aus beispielsweise Trifluormethan CHF₃ und Argon Ar durchgeführt. Das Gemisch besitzt dabei einen Gasfluß von vorzugsweise 0 bis 100 sccm und einen Prozeßdruck zwischen 10 und 100 µbar. Über den Resonator wird bei einer Leistung zwischen vorzugsweise 300 und 1200 W eine Mikrowelleneinstrahlung und damit ein Plasma erzeugt.

Während des Polymerisationsschrittes werden die im vorhergehenden Ätzschritt freigelegten Flächen, also der Ätzgrund und die Seitenflächen, sehr gleichmäßig mit einem Polymer bedeckt. Diese Polymerschicht auf den Ätzkanten bzw. Ätzflächen bildet einen sehr wirkungsvollen vorläufigen Ätzstopp.

Das jeweils im Polymerisationsschritt auf die Ätzkante aufgebrachte Polymer wird während des nunmehr darauffolgenden zweiten Ätzschrittes teilweise wieder abgetragen. Die beim Weiterätzen freigelegte Kante erfährt bereits während des Ätzschrittes durch vom darüberliegenden Kantenbereich teilweise abgetragenen Polymer lokal einen wirksamen Schutz vor einen weiteren Ätzangriff.

Die bekannte Tendenz freigesetzter Monomere, sich bereits unmittelbar benachbart wieder niederzuschlagen, hat beim erfindungsgemäßen Verfahren die positive Konsequenz, einen zusätzlichen lokalen Kantenschutz beim Weiterätzen zu bewirken. Hieraus ergibt sich, daß die Anisotropie der einzelnen Ätzschritte, die ja getrennt von den Polymerisationsschritten im Plasma erfolgen, durch diesen Effekt signifikant erhöht wird.

Die auf dem Ätzgrund während des Polymerisationsschrittes aufgebrachte Polymerschicht wird während des darauffolgenden Ätzschrittes rasch durchbrochen, da das Polymer mit der Ionenunterstützung sehr schnell abgetragen wird und die chemische Umsetzung der reaktiven Plasmaspezies mit dem Silicium am Ätzgrund voranschreiten kann.

Die Seitenwände der einzuätzenden Strukturen bleiben während des Ätzschrittes durch das während des Polymerisatonsschrittes aufgebrachte Polymer geschützt.

Die Ätzschritte und die Polymerisationsschritte werden so oft alternierend wiederholt, bis die vorherbestimmte Ätztiefe der Strukturen im Siliciumsubstrat erreicht ist. Die Dauer der einzelnen Ätzschritte liegen bei dem mikrowellenunterstützten Verfahren, das eine Ätzrate zwischen 2 und 20 µm/min ermöglicht, so, daß pro Ätzschritt z.B. 2 bis 3 µm Tiefe weitergeätzt wird.

Der nachfolgende Polymerisationsschritt wird etwa solange gewählt, daß während der Polymerisationszeit eine ca. 50 nm starke teflonartige Polymerschicht an den Seitenwänden bzw. auf dem Ätzgrund abgeschieden ist. Dafür wird z.B. eine Zeit von einer Minute benötigt.

In vorteilhafter Ausgestaltung des Polymerisationsschrittes wird gleichzeitig mit der Polymeraufbringung eine Ioneneinwirkung auf das Siliciumsubstrat durchgeführt. Dazu wird die Substratelektrode mit einer Hochfrequenzleistung von beispielweise 3 bis 5 W, die eine Substratvorspannung von ca. 5 V ergibt, beaufschlagt. Da ohne die Ioneneinwirkung die während des Polymerisationsschrittes abgeschiedenen Polymerschichten während der Ätzschritte nur sehr langsam geätzt - nur wenige Nanometer pro Minute - werden, bietet die gleichzeitige Ioneneinwirkung während des Ätzschrittes den Vorteil, daß die Polymer-Ätzrate drastisch auf über 100 nm/min gesteigert werden kann. Dies wird selbst dann erreicht, wenn das Siliciumsubstrat auch nur mit einer geringen Ionenenergie, z.B. 5 eV, bombardiert wird.

Wird das Siliciumsubstrat bereits während der Polymerisationsschritte mit geringer Ionenenergie bombardiert, kann auf dem Ätzgrund überhaupt kein Polymer gebildet werden. Die polymerisationsfähigen Monomere reichern sich daher bevorzugt an den Seitenwände an und entfalten dort einen besonders wirksamen Schutz vor dem darauffolgenden Ätzschritt, wogegen der Ätzgrund frei bleibt von jeglicher Bedeckung.

Beim darauffolgenden Ätzschritt kann also am Ätzgrund ohne Verzug, das heißt ohne vorheriges Abtragen eines Polymerfilms, weitergeätzt werden.

Mit beiden Alternativen, also Ioneneinwirkung nur während der Ätzphase bzw. Ioneneinwirkung während der Ätzphase und der Polymerisationsphase, können Strukturen mit sehr hoher Anisotropie, das heißt mit praktisch genau senkrechten Kantenprofilen, erreicht werden.

Es ist ein besonderer Vorzug, daß ein anisotropes Ergebnis mit außerordentlich niedrigen Ionenenergien erreicht werden kann. Soll während des Polymerisationsschrittes auf dem Ätzgrund kein Polymer deponiert werden, genügen bereits Ionenenergien von nur ca. 5 eV. Bei den Ätzschritten empfiehlt sich ein Ionenbombardement bei Energien zwischen 5 und 30 eV, um den Strukturgrund völlig freizuhalten von Depositionen aus dem Plasma, so daß sich erst keine Ätzgrundrauhigkeit einstellen kann.

Werden nur während der Ätzschritte Ionen zum Siliciumsubstrat beschleunigt, so genügen diese auch, um das Ätzgrundpolymer, das sich während der Polymerisationsschritte absetzt, innerhalb von einigen Sekunden zu durchbrechen. Bei dieser Betriebsart wird der Microloading-Effekt in der Ätzrate noch weiter reduziert.

Die Siliciumätzung an sich erfordert dank der hohen spontanen Umsetzungsrate von Fluorradikalen mit Silicium keinerlei Ionenunterstützung.

Ein weiterer wesentlicher Vorteil ergibt sich daraus, daß infolge der nur geringen benötigten Ionenenergien eine ausgezeichnete Maskenselektivität erreicht wird. Ionenenergien in der angegebenen Größenordnung genügen nicht, um die Ätzung der Maskenmaterialien, z.B. Photolack und Siliciumoxid SiO₂ zu induzieren, da die Aktivierungsenergie für das Aufbrechen chemischer Bindungen im hochgradig vernetzten Maskenpolymer erheblich höher liegt. Ohne ein vorheriges Aufbrechen dieser Bindungen ist es den Ätzspezies jedoch nicht möglich, mit dem Maskenmaterial zu flüchtigen Verbindungen zu reagieren, die anschließend desorbiert werden können.

Da mit dem beschriebenen Verfahren hohe Ätzraten erreicht werden können, kommt es durch die stark exotherme chemische Umsetzung von Fluorradikalen mit Silicium zu einer Erwärmung des Siliciumsubstrats. Bei entsprechend hohen Temperaturen verlieren die während des Polymerisationsschrittes deponierten Polymere bzw. auch die Maskenmaterialien, z.B. Photolack, ihre Beständigkeit gegenüber den Ätzspezien. Daher ist es notwendig, für eine hinreichende Kühlung der Siliciumsubstrate zu sorgen. Dies wird mit an sich bekannten Verfahren, z.B. die Kühlung der Siliciumsubstratrückseite durch einen Heliumgasstrom oder das Aufkleben der Siliciumsubstrate auf gekühlte Siliciumelektroden, erreicht.

Anstelle der beschriebenen Gemische von Schwefelhexafluorid und Argon für die Ätzschritte bzw. von Trifluormethan und Argon für die Polymerisationsschritte können genauso gut für die Ätzschritte andere gebräuchliche, Fluor liefernde Ätzgase, beispielweise Stickstofftrifluorid NF₃, oder ähnliches und für die Polymerisationsschritte Gemische auf Basis von perfluorierten Aromaten mit geeigneten Randgruppen, beispielsweise perfluorierte styrolartige Monomere oder etherartige Fluorverbindungen eingesetzt werden.

Bei allen eingesetzten Medien kommt es lediglich darauf an, hohe Dichten von reaktiven Spezies und Ionen bei gleichzeitig geringer, aber exakt kontrollierbarer Energie zu erreichen, mit der die generierten Ionen die Substrate erreichen.

Die Ionenenergie muß mit Rücksicht auf eine hohe Maskenselektivität so klein wie möglich gehalten werden. Hohe Ionenenergien würden zudem zu störenden Rückwirkungen von zerstäubten oder abgetragenen und unkontrolliert redeponiertem Material führen. Die Energie der auf das Siliciumsubstrat einwirkenden Ionen muß jedoch ausreichen, um den Strukturgrund von Depositionen freizuhalten, damit ein glatter Ätzgrund erreicht werden kann.

## Patentansprüche

1. Verfahren zum anisotropen Plasmaätzen von mit einer Ätzmaske lateral exakt definierten Strukturen in einem Siliziumsubstrat durch jeweils alternierend aufeinanderfolgende, separate Durchführung von Ätz- und Polymerisationsschritten, die unabhängig voneinander gesteuert werden, wobei das Siliziumsubstrat auf einer Substratelektrode in einem Reaktor angeordnet ist und wobei während des Polymerisationsschrittes auf die durch die Ätzmaske definierten lateralen Strukturen ein Polymer aufgebracht wird, das während des nachfolgenden Ätzschrittes teilweise wieder abgetragen wird, dadurch gekennzeichnet, daß
- die Ätzschritte ohne Polymerbildner im Plasma durchgeführt werden,
- für die Polymerisationsschritte Fluorkohlenwasserstoffe mit niedrigem Fluor-zu-Kohlenstoff-Verhältnis eingesetzt werden, wobei die durch die vorhergehenden Ätzschritte freigelegten Flächen mit einem teflonartigen, chlorfreien Polymer bedeckt werden,
- für die Ätzschritte Fluor liefernde Ätzgase eingesetzt werden, und
- die Substratelektrode während der Ätzschritte mit einer Hochfrequenz niedriger Leistung beaufschlagt wird.

2. Verfahren nach Anspruch 1, dadurch gekennzeichnet, daß die Ätzschritte über eine Zeitspanne, die die Ätztiefe bestimmt, durchgeführt werden.

3. Verfahren nach einem der vorhergehenden Ansprüche, dadurch gekennzeichnet, daß die Polymerisationsschritte über eine, die Dicke der Polymerabscheidungen bestimmende Zeitspanne durchgeführt werden.

4. Verfahren nach einem der vorhergehenden Ansprüche, dadurch gekennzeichnet, daß die Siliciumsubstrate wahlweise während der Polymerisationsschritte mit einer Ionenenergie bombardiert werden.

5. Verfahren nach einem der vorhergehenden Ansprüche, dadurch gekennzeichnet, daß die Ionenenergie während der Ätzschritte zwischen 1 und 50, vorzugsweise zwischen 5 und 30 eV, beträgt.

6. Verfahren nach einem der vorhergehenden Ansprüche, dadurch gekennzeichnet, daß die Ionenenergie während der Polymerisationsschritte zwischen 1 und 10, vorzugsweise 4 bis 6, insbesondere 5 eV beträgt.

7. Verfahren nach einem der vorhergehenden Ansprüche, dadurch gekennzeichnet, daß für die Ätzschritte ein Gemisch von Schwefelhexafluorid SF₆ und Argon Ar eingesetzt wird.

8. Verfahren nach einem der vorhergehenden Ansprüche, dadurch gekennzeichnet, daß für die Polymerisationsschritte ein Gemisch von Trifluormethan CHF₃ und Argon Ar eingesetzt wird.

9. Verfahren nach einem der vorhergehenden Ansprüche, dadurch gekennzeichnet, daß die für die Ätzschritte und Polymerisationsschritte eingesetzten Medien vorzugsweise Gasflüsse von 0 bis 100 sccm und vorzugsweise Prozeßdrücke von 10 bis 100 µbar aufweisen.

10. Verfahren nach einem der vorhergehenden Ansprüche, dadurch gekennzeichnet, daß die Plasmaerzeugung vorzugsweise mit Mikrowelleneinstrahlung bei Leistungen zwischen 100 und 1500, vorzugsweise 300 bis 1200 W erfolgt.

11. Verfahren nach einem der vorhergehenden Ansprüche, dadurch gekennzeichnet, daß die Siliciumsubstrate während der Ätzschritte und/oder Polymerisationsschritte gekühlt werden.

12. Verfahren nach einem der vorhergehenden Ansprüche, dadurch gekennzeichnet, daß die Siliciumsubstrate rückseitig mit einem Heliumgasstrom beaufschlagt werden.

13. Verfahren nach einem der vorhergehenden Ansprüche, dadurch gekennzeichnet, daß die Siliciumsubstate über ein Wärmekontaktmaterial auf eine gekühlte Substratelektrode aufgebracht werden.

14. Verfahren nach einem der vorhergehenden Ansprüche, dadurch gekennzeichnet, daß die Ätzschritte und Polymerisationsschritte mit einer hohen Plasmadichte an raktiven Spezies und Ionen durchgeführt werden.

15. Verfahren nach einem der vorhergehenden Ansprüche, dadurch gekennzeichnet, daß die Plasmadichte und die Ionenenergie unabhängig voneinander geregelt werden.

## Claims

1. Process for the anisotropic plasma etching of structures in a silicon substrate which are exactly defined laterally by an etching mask, by respectively alternating separate implementation of etching and polymerization steps, which are controlled independently of one another, the silicon substrate being arranged on a substrate electrode in a reactor, and, during the polymerization step, a polymer, which is partially removed during the subsequent etching step, being applied to the lateral structures defined by the etching mask, characterized in that
- the etching steps are carried out without polymer-forming substances in the plasma,
- fluorohydrocarbons with low fluorine-to-carbon ratio are used for the polymerization steps, the areas exposed by the preceding etching steps being covered with a chlorine-free polymer of the polytetrafluoroethylene type,
- etching gases which supply fluorine are used for the etching steps, and
- a low-power radio frequency is applied to the substrate electrode during the etching steps.

2. Process according to Claim 1, characterized in that the etching steps are carried out for a length of time which determines the etching depth.

3. Process according to one of the preceding claims, characterized in that the polymerization steps are carried out for a length of time which determines the thickness of the polymer deposits.

4. Process according to one of the preceding claims, characterized in that the silicon substrates are selectively bombarded with ion energy during the polymerization steps.

5. Process according to one of the preceding claims, characterized in that the ion energy during the etching steps is between 1 and 50, preferably between 5 and 30 eV.

6. Process according to one of the preceding claims, characterized in that the ion energy during the polymerization steps is between 1 and 10, preferably 4 to 6, in particular 5 eV.

7. Process according to one of the preceding claims, characterized in that a mixture of sulphur hexafluoride SF₆ and argon Ar is used for the etching steps.

8. Process according to one of the preceding claims, characterized in that a mixture of trifluoromethane CHF₃ and argon Ar is used for the polymerization steps.

9. Process according to one of the preceding claims, characterized in that the media used for the etching steps and polymerization steps preferably have gas flow rates of 0 to 100 sccm and, preferably, process pressures of from 10 to 100 µbar.

10. Process according to one of the preceding claims, characterized in that the plasma production preferably takes place with microwave irradiation at powers of between 100 and 1500, preferably 300 to 1200 W.

11. Process according to one of the preceding claims, characterized in that the silicon substrates are cooled during the etching steps and/or polymerization steps.

12. Process according to one of the preceding claims, characterized in that a helium gas flow is applied to the back of the silicon substrate.

13. Process according to one of the preceding claims, characterized in that the silicon substrate is applied to a cooled substrate electrode via a thermal contact material.

14. Process according to one of the preceding claims, characterized in that the etching steps and polymerization steps are carried out with a high plasma density of reactive species and ions.

15. Process according to one of the preceding claims, characterized in that the plasma density and the ion energy are controlled independently of one another.

## Revendications

1. Procédé d'attaque anisotrope au plasma de structure à définition latérale exacte par un masque d'attaque dans un substrat de silicium par une succession alternée d'étapes d'attaque et de polymérisation effectuées séparément et commandées indépendamment l'une de l'autre, le substrat de silicium étant placé sur une électrode à substrat dans un réacteur et pendant l'étape de polymérisation, on applique un polymère sur les structures latérales définies par le masque d'attaque, ce polymère étant de nouveau enlevé partiellement pendant l'étape d'attaque suivante,
caractérisé en ce qu'
- on effectue l'étape d'attaque sans générateur de polymère dans le plasma,
- pour l'étape de polymérisation, on utilise des hydrocarbures fluorés à faible rapport fluore/carbone, les surfaces dégagées par l'étape d'attaque précédente étant revêtues d'un polymère de type Téflon, sans chlore,
- pour l'étape d'attaque, on utilise des gaz d'attaque fournissant du fluor et,
- pendant l'étape d'attaque, l'électrode de substrat reçoit une puissance faible à haute fréquence.

2. Procédé selon la revendication 1,
caractérisé en ce qu'
on effectue l'étape d'attaque pendant une durée qui définit la profondeur d'attaque.

3. Procédé selon l'une quelconque des revendications précédentes,
caractérisé en ce qu'
on effectue l'étape de polymérisation pendant une durée qui définit l'épaisseur des dépôts de polymère.

4. Procédé selon l'une quelconque des revendications précédentes,
caractérisé en ce qu'
on bombarde le substrat de silicium au choix pendant l'étape de polymérisation avec une énergie ionique.

5. Procédé selon l'une quelconque des revendications précédentes,
caractérisé en ce que
l'énergie ionique pendant l'étape d'attaque est comprise entre 1 et 50, de préférence entre 5 et 30 eV.

6. Procédé selon l'une quelconque des revendications précédentes,
caractérisé en ce que
l'énergie ionique pendant l'étape de polymérisation est comprise entre 1 et 10 et de préférence 4 et 6 et notamment 5 eV.

7. Procédé selon l'une quelconque des revendications précédentes,
caractérisé en ce que
pour l'étape de polymérisation, on utilise un mélange d'hexaflorure de soufre SF₆ et d'argon Ar.

8. Procédé selon l'une quelconque des revendications précédentes,
caractérisé en ce que
pour l'étape de polymérisation, on utilise un mélange de trifluorure de méthane CHF₃ et d'argon Ar.

9. Procédé selon l'une quelconque des revendications précédentes,
caractérisé en ce que
les milieux utilisés pour l'étape d'attaque et l'étape de polymérisation correspondent de préférence à des débits gazeux de 0 à 100 cm³/s et de préférence des pressions de procédé comprises entre 10 et 100 µbars.

10. Procédé selon l'une quelconque des revendications précédentes,
caractérisé en ce qu'
on génère le plasma de préférence avec un rayonnement induit de micro-ondes à des puissances comprises entre 100 et 1500 et de préférence 300 à 1200 W.

11. Procédé selon l'une quelconque des revendications précédentes,
caractérisé en ce qu'
on refroidit le substrat de silicium pendant l'étape d'attaque et/ou l'étape de polymérisation.

12. Procédé selon l'une quelconque des revendications précédentes,
caractérisé en ce qu'
on applique un flux d'hélium gazeux sur la face arrière du substrat de silicium.

13. Procédé selon l'une quelconque des revendications précédentes,
caractérisé en ce qu'
on applique le substrat de silicium sur une électrode de substrat refroidie par l'intermédiaire d'une matière de contact thermique.

14. Procédé selon l'une quelconque des revendications précédentes,
caractérisé en ce qu'
on exécute l'étape d'attaque et l'étape de polymérisation avec une forte densité de plasma en composants réactifs et en ions.

15. Procédé selon l'une quelconque des revendications précédentes,
caractérisé en ce qu'
on régule indépendamment la densité du plasma et l'énergie ionique.
